Europäisches Patentamt

(19) European Patent Office

Office européen des brevets

(11) Publication number:

**0 097 533**
**B1**

(12) **EUROPEAN PATENT SPECIFICATION**

(45) Date of publication of patent specification: 21.01.87

(21) Application number: 83303587.6

(22) Date of filing: 22.06.83

(51) Int. Cl.⁴: **H 01 L 21/265,**
**H 01 L 21/268, H 01 L 29/08**

(54) A method of manufacturing a MIS type semiconductor device.

(30) Priority: 23.06.82 JP 108003/82

(43) Date of publication of application:
04.01.84 Bulletin 84/01

(45) Publication of the grant of the patent:
21.01.87 Bulletin 87/04

(84) Designated Contracting States:
DE FR GB

(56) References cited:
EP-A-0 010 942
FR-A-2 236 271

G.E.C. JOURNAL OF SCIENCE &
TECHNOLOGY, vol. 48, no. 2, 1982, pages
112-118, RUGBY, (GB), A.E. ADAMS et al.:
"Radiant-beam processing of semiconductor
structures"

APPLIED PHYSICS LETTERS, vol. 36, no. 9, May
1980, pages 765-768, NEW YORK (US), A.
LIETOILA et al.: "The solid solubility and
thermal behavior of metastable concentrations
of As in Si"

(73) Proprietor: FUJITSU LIMITED
1015, Kamikodanaka Nakahara-ku
Kawasaki-shi Kanagawa 211 (JP)

(72) Inventor: Yahano, Toshi c/o FUJITSU LIMITED
Patent Department 1015 Kamikodanaka
Nakahara-ku
Kawasaki-shi Kanagawa 211 (JP)

(74) Representative: Sunderland, James Harry et al
HASELTINE LAKE & CO Hazlitt House 28
Southampton Buildings Chancery Lane
London WC2A 1AT (GB)

(56) References cited:

APPLIED PHYSICS LETTERS, vol. 39, no. 2, July
1981, pages 150-152, NEW YORK (US), R.A.
POWELL et al.: "Activation of arsenic-
implanted silicon using an incoherent light
source"

APPLIED PHYSICS LETTERS, vol. 37, no. 11,
December 1, 1980, pages 1036-1037, NEW
YORK (US), H.J. SMITH et al.: "Scanned
electron beam annealing of arsenic-implanted
silicon"

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

(56) References cited:

NUCLEAR INSTRUMENTS & METHODS, vol. 182/183, Part 1, April/May 1981, pages 389-395, AMSTERDAM (NL), J.S. WILLIAMS et al.: "Limits to solid solubility in ion implanted silicon"

NUCLEAR INSTRUMENTS & METHODS, vol. 182/183, Part 2, April/May, 1981, pages 573-579, AMSTERDAM (NL), G. FOTI: "Post-implantation processes in semiconductors"

**Description**

This invention relates to a method of manufacturing an MIS (Metal-Insulator-Semiconductor) type semiconductor device and more specifically to a method of forming an impurity region for an MIS type device in a semiconductor substrate using an ion implantation method.

As semiconductor device elements have become progressively more miniaturized in order to provide semiconductor devices with higher integration densities, ion-implantation methods have been more widely used for accurately forming impurity regions having desired impurity concentration profiles.

An ion implantation method has a variety of merits as compared with a thermal diffusion method; for example fluctuation of sheet resistance, of an implantated layer, can be relatively reduced, impurity concentration can be increased, processing can be executed at a comparatively low temperature and within a short period of time, junction depth can be controlled with excellent accuracy, complicated impurity profiles can be formed rather easily, and pattern accuracy can be improved. From G.E.C Journal of Science and Technology, Vol. 48, No. 2, 1982, pages 112—118, there is known a method of manufacturing an MIS type semiconductor device having an impurity region formed in a semiconductor substrate, the method comprising the steps of; implanting impurity ions into the semiconductor substrate and irradiating the impurity region with an energy beam to render the implanted impurity in the region electrically active without any substantial redistribution of the impurity.

It has been found that a solid solubility at which impurity becomes active electrically in a semiconductor material lies at a point lower than a metallurgical solid solubility wherein impurity is capable of being solved (dissolved) into the semiconductor material under the thermal equilibrium state on the occasion of implanting impurity into a semiconductor base material.

The former solid solubility is called the electrically active solubility, and it is about, for example, $2 \sim 6 \times 10^{20}$ (atm/cm$^3$) in a case in which arsenic (As) is implanted as an impurity into silicon (Si); see for instance: Appl. Phys. Lett. Vol. 36, No. 9, May 1980, pages 765—768.

When impurity atoms in excess of said electrical active solubility are present in an impurity region, the excessive impurity atoms act as traps for carriers, or reduce carrier mobility, thereby increasing the sheet resistance of the impurity region, or increasing leakage current, and accordingly degrading the performance of completed semiconductor elements.

MIS type semiconductor devices, particularly MIS IC's are in many cases so designed that impurity regions function as wiring, and it is very desirable that the sheet resistance of such impurity regions is kept as low as possible, even with increased integration density.

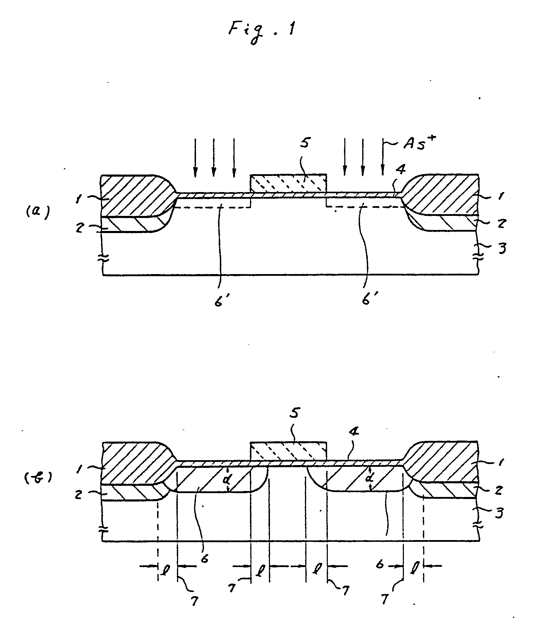

Conventionally, when forming for example an n-channel type MIS-IC by an ion implantation method using As as impurity, as illustrated in Fig. 1(a) of the accompanying drawings a gate oxide film 4 is formed with a thickness of about 50 nm (500 (Å)) on a surface portion of a p type Si substrate 3 having an impurity concentration of about $10^{15}$ (atm/cm$^3$), which surface portion is exposed and surrounded by a field isolation oxide film 1 and a p$^+$ type channel cut region 2. A polycrystal Si gate electrode 5 is formed on the gate oxide film 4 with a thickness of about 300~400 nm (3000~4000 (Å)) and thereafter arsenic ions (As$^+$) are implanted with a dosage of about $4 \times 10^{15}$ (atm/cm$^2$) and an energy in the range 100~150 (KeV), for example 120 (KeV), into the surface of the p type Si substrate 3, through the gate oxide film 4 using the gate electrode 5 as a mask (6' in Fig. 1(a) indicating the As$^+$ implantation regions).

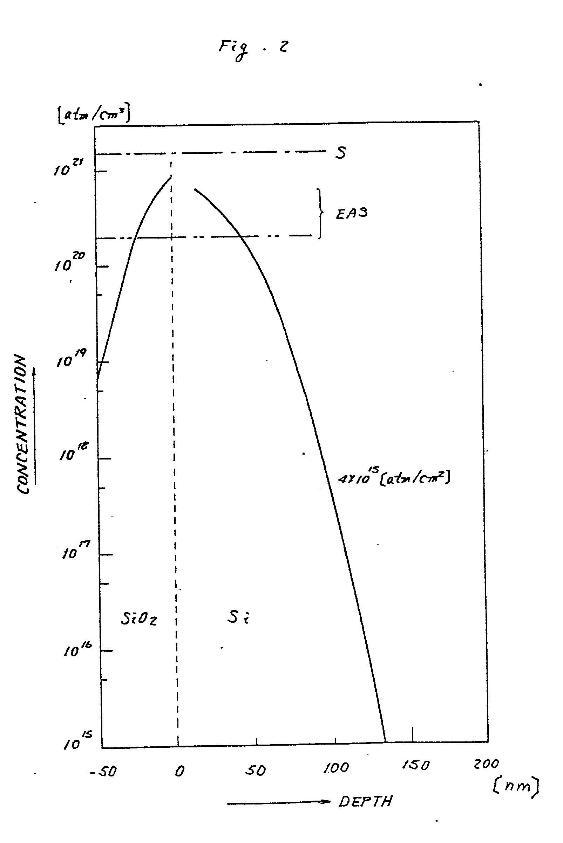

Fig. 2 of the accompanying drawings is a graph illustrating an As concentration profile for an As implantation region thus formed. In this graph, the curve shows As concentration versus depth $d$. S is metallurgical solid solubility at 1100(°C) and EAS is electrically active solubility. The region labelled SiO$_2$ corresponds to the gate oxide film region (4—in Fig. 1(a) and the region labelled Si corresponds to the p type Si substrate region (3- in Fig. 1(a)).

In the conventional method, As is implanted in such amount as is required to obtain a desired low sheet resistance, without particular consideration being given to electrically active solubility. Therefore, as shown in Fig. 2, the peak value of the concentration of As is larger than the electrically active solubility. However, in the conventional method, As is redistributed by thermal treatment in subsequent process steps, with the result that the peak value of As concentration is reduced.

After As implantation, the substrate is heated in an electric furnace for about 30 (min) at a temperature as high as about 1000(°C) in a nitrogen (N$_2$) ambient, and is annealed in order to activate the As$^+$ implantation region 5. As explained above, As is redistributed in this process.

In Fig. 1(b) of the accompanying drawings conditions after such annealing are illustrated. In Fig. 1(b), 6 indicates As diffused regions (n$^+$ type source/drain regions) formed by annealing the As implantation region.

As shown in Fig. 1(b), the implanted As is diffused by the annealing process and thereby As diffused regions (source/drain regions) 6 are formed with a depth (d) of about 400 nm (4000(Å)). The As diffused regions expand in the lateral direction by an amount l which is almost equal to the depth of the diffused regions at the mask ends 7 (l is about 300 nm (3000(Å))).

For this reason, the conventional method gives rise to a problem in that such lateral diffusion militates against the provision of a high integration desnity of elements.

Moreover, the conventional high temperature-heated annealing process has been accompanied by a problem in that the amount or extent of such lateral diffusion is subject to variations because the concentration profile of As in the diffused regions cannot be controlled strictly, and consequently the characteristics of elements vary due to variations in channel length of MIS type transistors formed in this way.

To alleviate the above problems it has been attempted to effect shallow formation of diffused regions. In such a case, however, the total amount of As in a diffused region runs short and accordingly the desired low· sheet resistance value cannot be obtained. It has also been attempted to activate the ion-implanted impurity by irradiation with an energy beam, accordingly to activate the impurity without any substantial redistribution thereof. When impurity redistribution does not occur, the impurity does not expand laterally. However, impurity implanted to a concentration exceeding the electrically active solubility is not activated, because its concentration is never reduced below the electrically active solubility by redistribution. Nevertheless, if an ion implantation ion method is used, a large amount of impurity must be implanted, such that its peak concentration exceeds the electrically active solubility, in order to obtain the generally desired low sheet resistance for an MIS type semiconductor device.

According to the present invention there is provided a method of manufacturing an MIS type semiconductor device having an impurity region formed in a semiconductor substrate,

the method comprising the steps of:

implanting impurity ions into the semiconductor substrate using a plurality of implantation energies

and implantation dosages, to form the impurity region, the energies and dosages being selected to provide an impurity distribution in the impurity region having a peak concentration which does not exceed the electrically active solubility of the impurity; and

irradiating the impurity region with an energy beam to render the implanted impurity in the region electrically active without any substantial redistribution of the impurity.

An embodiment of the present invention can provide a method of forming an impurity region, for an MIS type device, having a desired low sheet resistance, without causing lateral diffusion of impurity.

An embodiment of the present invention can prevent adverse effects on the characteristics of MIS type device which result when impurity concentration exceeds the electrically active solubility.

Briefly, the present invention provides a method of manufacturing an MIS type semiconductor device having an impurity region formed in a semiconductor device, the method comprising the steps of:

implanting ions of an impurity into said semiconductor substrate with a plurality of varied implantation energies and with an implantation dosage to form the impurity region, the energies and the dosage being selected to provide an impurity distribution in the region having a peak concentration which does not exceed the electrically active solubility of the impurity; and

irradiating the impurity region with an energy beam to render the implanted impurity in the region electrically active without any substantial redistribution of the impurity.

In a typical example in which the substrate is of silicon and the impurity is arsenic, electrically active solubility is $6 \times 10^{20}$ (atm/cm$^3$). As the energy beam, a light beam emitted from a xenon lamp, a laser beam or an electron beam can be used.

Reference is made, by way of example, to the accompanying drawings, in which:—

Figures 1(a) and (b) are cross-sectional views of a semiconductor substrate, illustrating stages in a conventional MIS type semiconductor device manufacturing process,

Figure 2 is graph illustrating a concentration profile of arsenic obtained when ions of arsenic are implanted in accordance with a conventional process,

Figure 3(a) to (d) are cross-sectional views of semiconductor substrate, illustrating the manufacture of an MIS type semiconductor device by a method embodying the present invention,

Figure 4 is a graph illustrating a concentration profile of arsenic obtained when arsenic ions are implanted in accordance with a method embodying the present invention, and

Figure 5 is a graph illustrating leakage current characteristics of a PN junction formed by arsenic ion implantation.

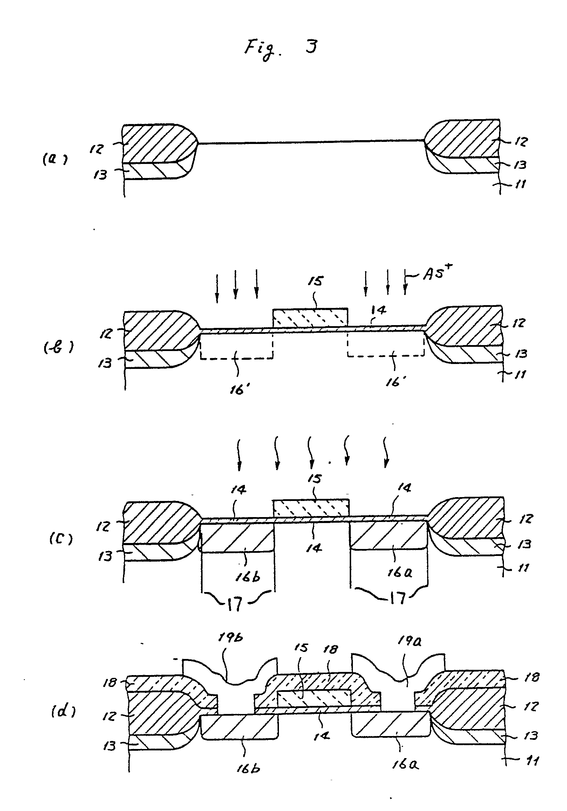

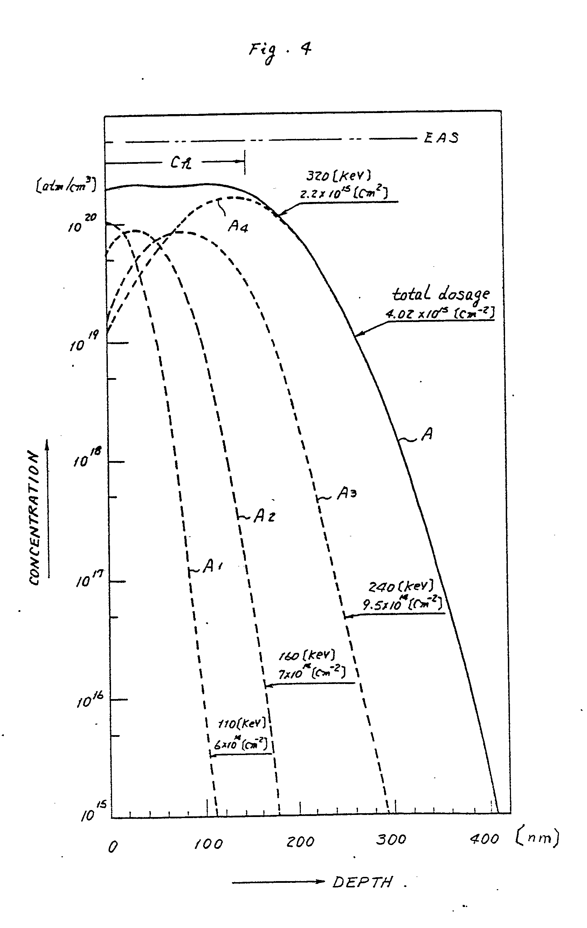

A preferred method embodying the present invention will be explained in detail with reference to the cross-sectional views of Figs. 3(a) to (d), illustrating the manufacturing processes involved, and to the Fig. 4 graph illustrating the arsenic (As) concentration profile of an As implanted region obtained by that method.

When forming, for example, an n channel MIS-IC by a method embodying the present invention, as shown in Fig. 3(a) a substrate is prepared by conventional means such that there are formed on a surface of a p type silicon (Si) substrate 11, having an impurity concentration of about $10^{15}$ (atm/cm$^3$) provided by a conventional process, a field isolation oxide film 12 and a p⁺ type channel cut region 13.

Then, as shown in Fig. 3(b), a gate oxide film 14 is formed to a thickness, for example of about 50 nm (500 (Å)) on the exposed surface of the p type Si substrate 11, by an ordinary thermal oxidation process and then a polycrystal Si gate electrode 15 is formed on the gate oxide film 14 by an ordinary chemical vapor deposition or patterning process.

In the method embodying the present invention, in order to form an arsenic (As) implanted region having a sheet resistance a low as about 20~30 (ohm-square), which is almost the same as that of such a region when an annealing method using an electric furnace is employed, successive As ion implantations are sequentially carried out under the following four different conditions: implantation energy of 110 (KeV) and dosage of $6 \times 10^{14}$ (atm/cm$^2$); implantation energy of 160 (KeV) and dosage of $7 \times 10^{14}$ (atm/cm$^2$); implantation energy of 240 (KeV) and dosage of $9.5 \times 10^{14}$ (atm/cm$^2$) and implantation energy of 320 (KeV) and dosage of $2.2 \times 10^{15}$ (atm/cm$^2$). Thereby, an impurity-implanted region can be formed wherein the peak concentration of the implanted As profile does not exceed the electrically active solubility of $6 \times 10^{20}$ (atm/cm).

In this implantation process, the field isolation oxide film 12 and the polycrystal Si gate electrode 15 function as an implantation mask, and the arsenic As is implanted into the surface of the p type Si substrate 11 through the gate oxide film 14 (16' is the As$^+$-implanted region).

The solid curve A in Fig. 4 indicates the profile of the total concentration of As in the p type Si substrate after the multiple As implantations under four different implantation conditions mentioned above.

In the graph of Fig. 4, As concentration is indicated along the vertical axis whilst depth from the Si substrate surface is indicated along the horizontal axis. The broken line curves A$_1$ to A$_4$ in the graph of Fig. 4 respectively indicate, for reference and comparison purposes, the concentration profiles of As provided by the individual implantations under the four different conditions.

As will be apparent from the graph of Fig. 4, the conditions of the multiple implantations are so preset that the peak value of the As concentration profile, after the multiple implantations, does not exceed the electrically active solubility EAS in silicon, since the EAS of As is about $2.5 \times 10^{20}$ (atm/cm$^3$). Moreover, it is desirable to preset the implantation conditions so that a region C$_h$, in which the concentration of As is near to the peak value, is as deep as possible. In addition, as explained above, since a p type Si substrate having an impurity concentration of about $10^{15}$ (atm/cm$^3$) is used, the junction depth is almost 400 nm (4000 (Å)).

Thereafter, the As$^+$ implanted region is irradiated with a light beam having an intensity of 26 (J/cm$^2$) is for a short period of about 400 (μs) with the substrate preheated, for example, to 450 to 550 (°C) by a heater in an underlying substrate holder. Thereby the implanted As is activated without any substantial redistribution. As a light source, for example a xenon flash lamp is used. By this activation process, As-implanted regions 16a and 16b of depths of about 400 nm (4000 (Å)), to provide N$^+$ type source/drain regions, are formed as shown in Fig. 3(c).

Sheet resistance of the As-implanted regions 16a and 16b after suffering such light irradiation annealing is as low as 20~30 (ohms), substantially same as the value obtained by the conventional high temperature annealing method. Moreover, since As is not redistributed during the light irradiation annealing process, the impurity regions do not substantially expand in the lateral direction from the mask edges 17. Therefore, diffusion of impurity in the lateral direction from mask edges is kept within 0.1 (μm), which is inevitably introduced by the implantation of As$^+$, in this embodiment of the present invention.

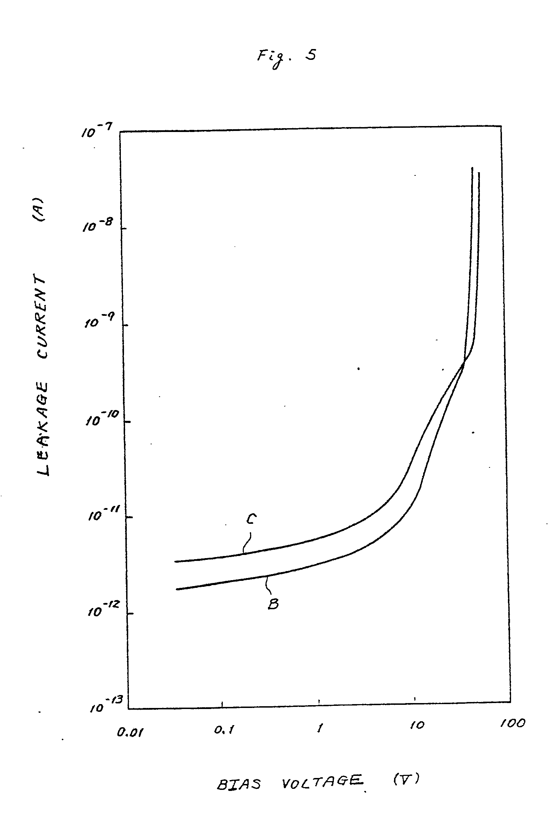

Fig. 5 is a graph illustrating leakage current characteristics of a PN junction between a p type substrate and an N$^+$ type region formed by an embodiment of this invention as explained with reference to Figs. 3 and 4, under the backward bias conditions. The horizontal axis indicates bias voltage, whilst the vertical axis indicates leakage current. Curve B illustrates the characteristic of the above-mentioned PN junction whilst curve C illustrates the characteristic of a differently formed PN junction, for comparison purposes.

This comparison junction was formed by a single As ion implantation with an implantation energy of 200 (KeV) and dosage of $1 \times 10^{16}$ (atm/cm$^3$). The substrate used, the annealing process and other conditions for formation of the comparison junction were the same as those for junction to which curve B relates. The resultant sheet resistance of the As-implanted region involved in the comparison junction is about 30 (ohms) and this is almost the same as is provided in relation to the curve B junction. However, in the comparison junction sample, leakage current is about doubled as compared with the curve B junction. Thereby, it must be concluded that the As region of the curve B junction has better characteristics.

After light irradiation annealing, as shown in Fig. 3(d) an insulating layer 18 is formed on the substrate by conventional means, electrode windows are formed in the insulating film and source/drain wirings 19a, 19b are formed, thus completing an n-channel MIS-IC.

In the above-described embodiment of this invention, dosage of As$^+$ is adjusted to a value near its electrically active solubility in order to reduce sheet resistance as far as possible, but if a higher sheet resistance is allowed a lower total dosage is naturally selected.

The present invention has been explained with reference to the formation of source/drain regions, but the method of this invention can also be applied for other purposes, for example in order to form wiring regions, such as bit wiring consisting of impurity introduced substrate regions.

As impurities to be implanted, those such as phosphorus (P), boron (B) can be employed, in addition to As. In addition, as energy beams for annealing processes for activation, a laser beam or an electron beam, for example, which are capable of instantly heating the substrate by irradiation, can be adopted.

As explained above, according to an embodiment of the present invention, when forming an impurity region having a low sheet resistance using an ion implantation method, lateral diffusion of the impurity region and fluctuation in size of region can be kept very small. This is very effective for providing high integration density in semiconductor devices and for equalization of characteristics.

A method embodying the present invention provides for forming an impurity region, for an MIS type semiconductor device, by activating through energy beam annealing an impurity implanted through multiple ion implantations using various implantation energies. The implantation energies and dosages are selected so that the total peak concentration of the resulting implantation profile does not exceed the electrically active solubility. Energy beam annealing is executed in such a way that implanted impurity is substantially activated without redistribution.

An impurity region of a low sheet resistance can been obtained, with suppression of lateral diffusion of impurity and without the defect of leakage current occurring due to excessive impurity.

## Claims

1. A method of manufacturing an MIS type semiconductor device having an impurity region formed in a semiconductor substrate,
    the method comprising the steps of:
    implanting impurity ions into the semiconductor substrate using a plurality of implantation energies and implantation dosages, to form the impurity region, the energies and the dosages being selected to provide an impurity distribution in the impurity region having a peak concentration which does not exceed the electrically active solubility of the impurity; and
    irradiating the impurity region with an energy beam to render the implanted impurity in the region electrically active without any substantial redistribution of the impurity.

2. A method as claimed in claim 1, wherein the substrate is of silicon and the impurity is arsenic respectively, and wherein said peak concentration is controlled so as not to exceed $6 \times 10^{20}$ (atm/cm$^3$).

3. A method as claimed in claim 1 or 2, wherein the energy beam is a light beam generated by a lamp.

4. A method as claimed in claim 3, wherein the lamp is a xenon lamp.

5. A method as claimed in claim 1 or 2, wherein the energy beam is a laser beam.

6. A method as claimed in claim 1 or 2, wherein the energy beam is an electron beam.

## Patentansprüche

1. Verfahren zur Herstellung einer Halbleitervorrichtung vom MIS-Typ mit einem Verunreinigungsbereich, der in einem Halbleitersubstrat gebildet wird,
    mit den folgenden Verfahrensschritten:
    Implantieren von Verunreinigungsionen in das Halbleitersubstrat, unter Verwendung einer Vielzahl von Implantationsenergien und Implantationsdosierungen, um den Verunreinigungsbereich zu bilden, wobei die Energien und die Dosierungen ausgewählt werden, um in dem Verunreinigungsbereich eine Verunreinigungsverteilung zu schaffen, die eine Spitzenkonzentration hat, welche die elektrisch aktive Löslichkeit der Verunreinigung nicht überschreitet; und
    Bestrahlen des Verunreinigungsbereichs mit einem Energiestrahl, um die implantierte Verunreinigung in dem Bereich elektrisch aktiv zu machen, ohne irgendeine wesentliche Umverteilung der Verunreinigung.

2. Verfahren nach Anspruch 1, bei welchem das Substrat aus Silizium besteht bzw. die Verunreinigung Arsen ist, und bei welchem die Spitzenkonzentration so gesteuert wird, daß sie $6 \times 10^{20}$ (atm/cm$^3$) nicht überschreitet.

3. Verfahren nach Anspruch 1 oder 2, bei welchem der Energiestrahl ein von einer Lampe erzeugter Lichtstrahl ist.

4. Verfahren nach Anspruch 3, bei welchem die Lampe eine Xenonlampe ist.

5. Verfahren nach Anspruch 1 oder 2, bei welchem der Energiestrahl ein Laserstrahl ist.

6. Verfahren nach Anspruch 1 oder 2, bei welchem der Energiestrahl ein Elektronenstrahl ist.

## Revendications

1. Procédé de fabrication d'un composant semiconducteur de type MIS comprenant une région d'impureté formée dans un substrat semiconducteur, le procédé consistant: à implanter des ions d'impureté dans le substrat semiconducteur en utilisant plusieurs énergies d'implantation et plusieurs dosages d'implantation pour former la région d'impureté, les énergies et les dosages étant choisis de manière à obtenir une distribution d'impureté dans la région d'impureté ayant une concentration de crête qui ne dépasse pas la solubilité active électriquement de l'impureté; et à irradier la région d'impureté avec un faisceau d'énergie pour rendre active électriquement l'impureté implanté dans la région sans redistribution substantielle de l'impureté.

2. Procédé selon la revendication 1 dans lequel le substrat est en silicium et l'impureté est de l'arsenic, et dans lequel ladite concentration de crête est contrôlée de manière à ne pas dépasser $6 \times 10^{20}$ atomes/cm$^3$.

3. Procédé selon la revendication 1 ou 2, dans lequel le faisceau d'énergie est un faisceau lumineux produit par une lampe.

4. Procédé selon la revendication 3, dans lequel la lampe est une lampe au xénon.

5. Procédé selon la revendication 1 ou 2, dans lequel le faisceau d'énergie est un faisceau laser.

6. Procédé selon la revendication 1 ou 2, dans lequel le faisceau d'énergie est un faisceau d'électrons.

Fig. 1

(a)

(b)

Fig . 2

Fig. 3

(a)

(b)

(c)

(d)

Fig . 4

Fig. 5